# EUROPÄISCHE PATENTSCHRIFT

(11) **EP 0 925 643 B1**
(45) Veröffentlichungstag und Bekanntmachung des Hinweises auf die Patenterteilung: **21.05.2003**
(21) Anmeldenummer: 97944860.2
(22) Anmeldetag: 09.09.1997
(51) Int. Cl.: H03F 1/32

(54) **VERSTÄRKERANORDNUNG HOHEN WIRKUNGSGRADES**
HIGH-EFFICIENCY AMPLIFYING DEVICE
DISPOSITIF D'AMPLIFICATION A RENDEMENT ELEVE

(30) Priorität: 14.09.1996 DE 19637582
(43) Veröffentlichungstag der Anmeldung: 30.06.1999
(73) Patentinhaber: Filtronic PLC, Saltaire, Shipley BD18 3TT (GB)
(72) Erfinder: BÖSCH, Wolfgang, D-89081 Ulm (DE); PETZ, Felix, Anton, D-94481 Haus im Wald (DE)
(74) Vertreter: Allman, Peter John
(86) Internationale Anmeldenummer: EP9704917
(87) Internationale Veröffentlichungsnummer: WO98011664

(56) Entgegenhaltungen:
- EP-A- 0 047 825
- EP-A- 0 252 364
- EP-A- 0 330 774
- US-A- 3 755 754

## Beschreibung

Die Erfindung betrifft eine Verstärkeranordnung hohen Wirkungsgrads.

Verstärker hohen Wirkungsgrads sind an sich seit langem bekannt, insbesondere in der Ausführung als sogenannte Klasse-F-Verstärker, siehe z.B. in "Solid State Radio Engineering" von Kraus und Bastian, John Wiley und Sons, New York, Abschnitt 14-4 Class F Amplification. Wesentlich bei Verstärkern im Klasse-F-Betrieb ist die Beschaltung des Ausgang mit Resonanzanordnungen für eine Grundfrequenz und mindestens eine Harmonische. Als Harmonische sind im Regelfall nur die doppelte oder nur die dreifache Grundfrequenz genutzt (z.B. RF Design, May 1996, S. 79-84:
"An Introduction to class F Power Amplitiers" von F.H. Raab).

Verstärker mit hohem Wirkungsgrad sind besonders interessant in akku- oder batteriebetriebenen Geräten bei hohen Frequenzen wie z.B. Mobiltelefonen, um mit dem begrenzten Energievorrat lange Betriebszeiten zu ermöglichen.

In IEEE MTT-S Digest 1996, S. 689-692 ist ein Verstärker hohen Wirkungsgrads für das 8 GHz-Band beschrieben, bei welchem in einer Vorverstärkerstufe vor dem Leistungsverstärkerelement aus einem sinusförmigen Eingangssignal ein trapezförmiges Halbwellen-Signal als Ansteuersignal für das Leistungsverstärkerelement, einen Feldeffekttransistor, erzeugt wird. Für die Erzeugung der Trapezform werden neben der Grundfrequenz fo die 3. und die 5. Harmonische, 3fo und 5fo, verwandt. In "High Efficiency Harmonic Control Amplifier" von Ingruber, Pritzel und Magerl beim IEEE Mtt-S Intern. Symposium on Microwaves 1996 ist eine Verstärkeranordnung beschrieben, bei welcher aus dem Eingangssignal in einer Vorstufe neben der Grundfrequenz Signalanteile bei der 2. Harmonischen erzeugt und für die Signalformung des Ansteuersignals verwandt werden, um ein annähernd halbbwellenförmiges Ansteuersignal zu erreichen.

Vorteilig bei Anordnungen mit Harmonischen im Ansteuersignal des Leistungsverstärkerelements ist, daß ohne den Leistungsverstärker zu übersteuern ein hoher Wirkungsgrad erreicht wird.

Nachteilig bei Anordnungen mit Harmonischen im Ansteuersignal des Leistungsverstärkerelements ist das Entstehen von

Intermodulationsprodukten im Ausgangssignal bedingt durch die Generation von Harmonischen. Die Intermodulationsprodukte bei der Grundfrequenz können nicht durch den ausgangsseitigen Grundfrequenz-Bandpaß unterdrückt werden.
Die US-A-3 755 754 offenbart eine Verstärkeranordnung hohen Wirkungsgrades, bei welcher in einer Vorstufe aus einem Eingangssignal ein Ansteuersignal für ein aktives Leistungsverstärkerelement derart abgeleitet wird, daß das Ansteuersignal Signalanteile bei der Grundfrequenz des Eingangssignals und bei mindestens einer Harmonischen dieser Grundfrequenz enthält, wobei die Verstärkungskennlinie der Vorstufe einen inversen Phasengang zum Leistungsverstärker bei der Grundfrequenz aufweist.

Aus EP-A 0 252 364 ist ebenfalls eine Verstärkeranordnung hohen Wirkungsgrades bekannt, bei der die Verstärkungskennlinie der Vorstufe für den Signalanteil bei der Grundfrequenz einen signalexpandierenden Verlauf aufweist.

Der vorliegenden Erfindung liegt die Aufgabe zugrunde, eine Verstärkeranordnung hohen Wirkungsgrads anzugeben, die bei geringem Aufwand eine gute Signalverstärkung mit geringen Störanteilen und hoher Linearität liefert.

Die Erfindung ist im Patentanspruch 1 beschrieben. Die Unteransprüche enthalten vorteilhafte Ausgestaltungen und Weiterbildungen der Erfindung.

Die erfindungsgemäße Verstärkeranordnung ermöglicht den Betrieb des aktiven Leistungsverstärkerelements in einem für den Gesamtwirkungsgrad günstigen nichtlinearen Kennlinienbereich und hält Signalverzerrungen gering, indem die Entstehung von Intermodulationsprodukten um die Grundfrequenz durch den gegenphasigen Einfluß der signalexpandierenden Kennlinie der Vorstufe und/oder dem inversen Phasengang weitgehend kompensiert wird.

Vorzugsweise wird die signalexpandierende Kennlinie durch Differenzbildung eines nach einer signalkomprimierenden Kennlinie erzeugten Zwischensignals gegenüber einem unverzerrten Eingangssignal realisiert. Die Signalanteile bei der mindestens einen Harmonischen sind vorteilhafterweise aus dem in der Vorstufe infolge der nichtlinearen Kennlinie entstehenden Signalgemisch abgeleitet.

In besonderen Fällen kann die Linearität des Leistungsverstärkers durch die Injektion der 2. und der 3. Harmonischen verbessert werden.

Die Erfindung ist nachfolgend anhand von Ausführungsbeispielen unter Bezugnahme auf die Abbildungen noch eingehend veranschaulicht. Dabei zeigt
- FIG. 1: eine bevorzugte Ausführung einer erfindungsgemäßen Anordnung
- FIG. 2: verschiedene Verstärkungskennlinien

Die skizzierte Anordnung enthält eine Leistungsverstärkerstufe HPA an sich bekannter Art, deren Ausgang mit einer harmonischen Last HL beschaltet ist. Die harmonische Last HL enthält insbesondere Resonanzkreise für die Grundfrequenz und mindestens eine Harmonische davon. Die Schaltungsteile zur Gleichstromversorgung sind der Übersichtlichkeit halber nicht mit eingezeichnet. Ausführungen für die Gleichstromschaltung und die harmonische Last sind aus dem Stand der Technik allgemein bekannt.

Eine Vorstufe V erzeugt aus einem hochfrequentem Eingangssignal Sᵢ ein Ansteuersignal S_{d} für das Leistungsverstärkerelement HPA. Die Vorstufe enthält eine Koppleranordnung mit zwei 3dB-Kopplern K1, K2. Der erste Koppler K1 teilt das an seinem einen Eingang 11 anliegende Eingangssignal Sᵢ auf zwei parallele Ausgänge 12, 14 auf. Einer der beiden Ausgänge (14) ist direkt mit einem ersten Eingang 23 des zweiten Kopplers K2 verbunden. Der andere Ausgang 12 des ersten Kopplers ist mit dem Eingang eines Vorverstärkers VV verbunden. Der Vorverstärker besitzt eine nichtlineare, signalkomprimierende Verstärkerkennlinie und ist vorzugsweise im B- oder AB-Modus betrieben. Das Ausgangssignal des Vorverstärkers VV enthält neben Signalanteilen der Grundfrequenz fo noch Signalanteile bei Harmonischen dieser Grundfrequenz und Intermodulationsprodukt und ist über einen Tiefpaß TP dem weiteren Eingang 21 des Kopplers K2 zugeführt.

Der Koppler K2 faßt die an seinen Eingängen 21, 23 anliegenden Signale so zusammen, daß an seinem einen Ausgang 22 ein Signal S₂₂ auftritt, welches für die Grundfrequenz fo einer Signalsubstraktion des Vorverstärkrt-Ausgangssignals S₂₁ von dem zum Eingangssignal Sᵢ direkt proportionalen Signals S₂₃ am Kopplereingang 23 entspricht. Die Signalsubtraktion wird durch Gegenphasigkeit der Grundfrequenz-Signalanteile bei der Signalzusammenfassung erreicht z.B. durch Einsatz zweier 90°-Koppler für K1 und K2. Wenn der Koppler K2 ein schmalbandiger Koppler ist, kann der Tiefpaß TP entfallen. Die nicht benötigten Anschlüsse 13 des ersten Kopplers und 24 des zweiten Kopplers sind mit Impedanzen R reflexionsfrei abgeschlossen.

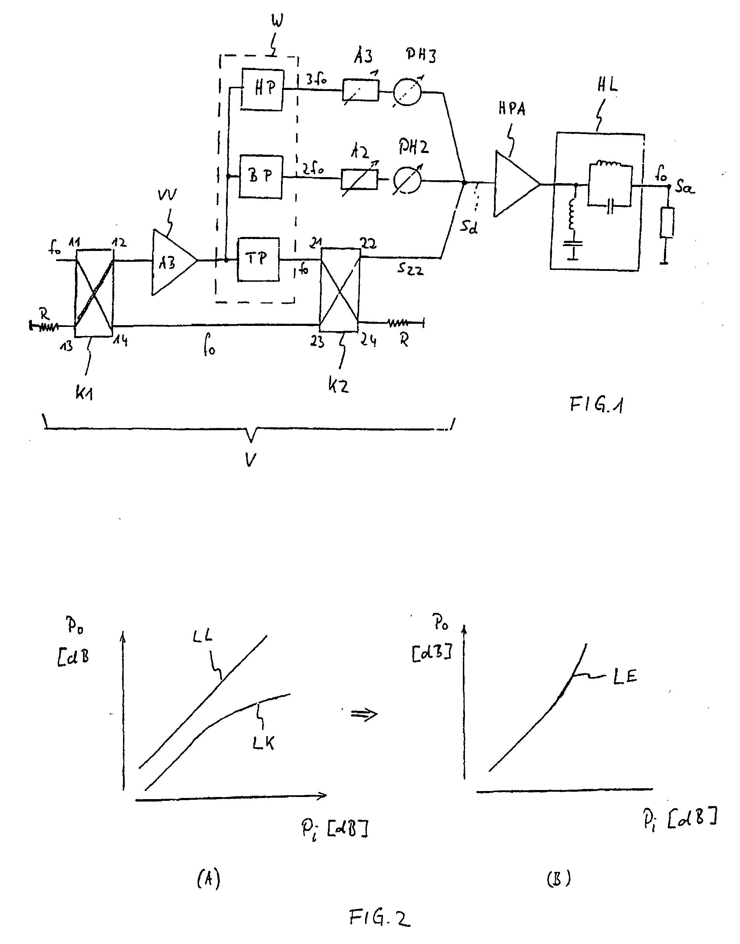

Das Ausgangssignal S₂₂ des zweiten Kopplers K2 zeigt bezüglich des Eingangssignals Sᵢ einen signalexpandierenden Verlauf LE wie in FIG. 2B als Ausgangsleistung Pₒ über der Eingangsleistung Pᵢ aufgetragen. Ein solcher Kennlinienverlauf wird vorteilhafterweise erzielt durch Erzeugen eines Signals mit signalkomprimierendem Kennlinienverlauf LK im Vorverstärker VV und Substraktion dieses Signals von einem leistungsstärkeren Signal mit linearem Kennlinienverlauf LL (FIG. 2A). In der Anordnung der FIG. 1 ist somit das Signal am Eingang 21 des zweiten Verstärkers mit geringerer Leistung als das Signal am anderen Eingang 23 dieses Kopplers, das heißt die Vorverstärkerstufe ist auf Signalverstärkung kleiner als eins (<OdB) eingestellt. Die gleichen Überlegungen, einen signalexpandierenden Verlauf zur Kompensation einer signalkompimierenden Leistungsstufe zu verwenden, sind auch für einen nichtlinearen (inversen) Phasengang über der Ausgangsleistung bei der Grundfrequenz gültig. Der Vorteil der skizzierten Anordnung liegt in dem einfachen Aufbau, bei welchem die signalkomprimierende Verstärkungskennlinie z.B. durch einen einstufigen Transistorverstärker realisierbar ist und dabei zugleich durch die Nichtlinearität der Kennlinie Signalanteile bei Harmonischen der Grundfrequenzen anfallen.

Aus dem Ausgangssignal des Vorverstärkers VV werden z.B. mittels eines weiteren Kopplers oder einer Frequenzweiche W, mit einem Tiefpaß TP für Anteile bei der Grundfrequenz fo, einem Bandpaß BP für Anteile bei der 2. Harmonischen 2fo und einem weiteren Bandpaß oder einem Hochpaß HP für Anteile bei der 3. Harmonischen 3fo, frequenzselektiv Anteile bei einer oder mehreren Harmonischen der Grundfrequenz, insbesondere bei der zweiten Harmonischen 2fo und/oder der dritten Harmonischen 3fo ausgefiltert und dem Signalanteil bei der Grundfrequenz im Ausgangssignal S₂₂ des zweiten Kopplers K2 zur Erzeugung des Ansteuersignals S_{d} für das Leistungsverstärkungselement PA wieder zugefügt. Zur Optimierung der Signalform des Ansteuersignals können in die Signalleitungen für die Signalanteile bei der Grundfrequenz einerseits und der Harmonischen anderseits Amplitudenstellglieder A2, A3 und/oder Phasenstellglieder PH3, PH2 eingefügt sein.

Zusätzlich oder alternativ zu der Verringerung der Intermodulationsprodukte bei hoher Linearität im Ausgangssignal des Leistungsverstärkers durch die expandierende Kennlinie des Ansteuersignals kann eine Verringerung der Intermodulationsprodukte und Verbesserung der Linearität durch Einprägung eines bestimmten Phasengangs in dem Ansteuersignal, der zu dem Phasengang der Leistungsverstärkerstufe invers ist, erzielt werden. Vorteilhafterweise ist ein solcher inverser Phasengang mit derselben Anordnung wie skizziert einfach erzeugbar, wenn Vorverstärker VV und Leistungsverstärker HPA denselben Phasengang aufweisen, was insbesondere der Fall ist bei gleicher Technologie der beiden Verstärker. Zur Erzeugung eines bestimmten Phasengangs können auch zusätzliche Phasenglieder vorgesehen sein.

Die Erfindung, die durch die Ansprüche definiert ist, ist nicht auf die beschriebenen Beispiele beschränkt, sondern im Rahmen fachmännischen Könnens in anderen Ausführungsformen realisierbar. Insbesondere können zwischen den Kopplern komplexere Schaltungsanordnungen mit Verstärker und Abschwächgliedern in beiden Signalwegen vorgesehen sein.

## Patentansprüche

1. Verstärkeranordnung hohen Wirkungsgrades, bei welcher in einer Vorstufe aus einem Eingangssignal ein Ansteuersignal (S_{d}) für ein aktives Leistungsverstärkerelement (HPA) derart abgeleitet wird, daß das Ansteuersignal (S_{d}) Signalanteile bei der Grundfrequenz (fo) des Eingangssignals und bei mindestens einer Harmonischen dieser Grundfrequenz enthält, **dadurch gekennzeichnet, daß** die Verstärkungskennlinie der Vorstufe für den Signalanteil bei der Grundfrequenz einen signalexpandierenden Verlauf und/oder einen inversen Phasengang zum Leistungsverstärker bei der Grundfrequenz aufweist, und daß der Signalanteil der mindestens einen Harmonischen (2fo, 3fo) aus dem Ausgangssignal des Vorverstärkerelements (VV) frequenzselektiv ausgekoppelt und mit dem Signalanteil (S₂₂) der Grundfrequenz (fo) mit expandierender Verstärkungskennlinie wieder zusammengefaßt ist.

2. Anordnung nach Anspruch 1, **dadurch gekennzeichnet, daß** die Vorstufe ein Vorverstärkerelement (VV) mit signalkomprimierender Verstärkungs-Kennlinie aufweist und die signalexpandierende Kennlinie der Vorstufe durch subtraktive Zusammenfassung des Ausgangssignals des Vorverstärkerelements mit einem linear vom Eingangasignal abhängigen Signalanteil gebildet ist.

3. Anordnung nach Anspruch 2, **dadurch gekennzeichnet, daß** das Vorverstärkerelement in einem von zwei Signalwegen zwischen zwei 3dB-Kopplern (k₁,k₂) angeordnet ist.

4. Anordnung nach einem der vorhergehenden Ansprüchen, **dadurch gekennzeichnet, daß** als die mindestens eine Harmonische die Harmonische (2fo) bei der doppelten Grundfrequenz gewählt ist.

## Claims

1. A high-efficiency amplifier arrangement in which in an preliminary stage a trigger signal (S_{d}) for an active power amplifier element (HPA) is derived from an input signal in such a way that the trigger signal (S_{d}) contains signal components at the fundamental frequency (f0) of the input signal and at least one harmonic of this fundamental frequency, **characterised in that** the amplification characteristic of the preliminary stage for the signal component at the fundamental frequency has a signal-expanding curve and/or an inverse phase response in relation to the power amplifier at the fundamental frequency, and **in that** the signal component of the at least one harmonic (2fo, 3fo) is coupled out of the output signal of the preamplifier element (VV) on a frequency-selective basis and is combined again with the signal component (S₂₂) of the fundamental frequency (f0) having an expanding amplification characteristic.

2. An arrangement according to Claim 1, **characterised in that** the preliminary stage has a preamplifier element with a signal-compressing amplification characteristic and the signal-expanding characteristic of the preliminary stage is formed by subtractive combining of the output signal of the preamplifier element (VV) with a signal component linearly dependent on the input signal.

3. An arrangement according to Claim 2, **characterised in that** the preamplifier element is arranged in one of two signal paths between two 3dB couplers (K1,K2).

4. An arrangement according to one of the preceding Claims, **characterised in that** the harmonic (2f0) at twice the fundamental frequency is selected as the at least one harmonic.

## Revendications

1. Dispositif amplificateur de haute efficacité, dans lequel, au cours d'un stade préliminaire, un signal de déclenchement (S_{d}) pour un élément amplificateur de puissance active (HPA) et dérivé d'un signal d'entrée, de sorte que le signal de déclenchement (S_{d}) contient des composantes du signal à la fréquence fondamentale (f0) du signal d'entrée et au moins une harmonique de cette fréquence fondamentale, **caractérisé en ce que** la caractéristique d'amplification de ce stade préliminaire pour la composante du signal à la fréquence fondamentale présente une courbe d'expansion du signal et/ou une caractéristique de phase inverse à l'amplificateur de puissance en présence de la fréquence fondamentale, et **en ce que** la composante du signal de la au moins une harmonique (2fo, 3fo) est découplée par sélection de la fréquence du signal de sortie de l'élément préamplificateur (VV) avant d'être combinée de nouveau avec la composante du signal (S₂₂) de fréquence fondamentale (f0) présentant une caractéristique d'amplification à expansion.

2. Dispositif selon la revendication 1, **caractérisé en ce que** le stade préliminaire comporte un élément préamplificateur (VV) avec une caractéristique d'amplification à compression du signal, la caractéristique à expansion du signal du stade préliminaire étant formée par combinaison soustractive du signal de sortie de l'élément préamplificateur avec une composante de signal à dépendance linéaire du signal d'entrée.

3. Dispositif selon la revendication 2, **caractérisé en ce que** l'élément préamplificateur est agencé dans un de deux parcours de signal entre deux coupleurs de 3 dB (K1, K2).

4. Dispositif selon l'une des revendications précédentes, **caractérisé en ce que** l'harmonique (2f0) à une fréquence représentant le double de la fréquence de base est sélectionnée comme la au moins une harmonique.
